## Europäisches Patentamt
## European Patent Office
## Office européen des brevets

(19)

(11) Veröffentlichungsnummer : **0 100 999**
**B1**

(12) **EUROPÄISCHE PATENTSCHRIFT**

(45) Veröffentlichungstag der Patentschrift :
**05.04.89**

(21) Anmeldenummer : **83107620.3**

(22) Anmeldetag : **02.08.83**

(51) Int. Cl.⁴ : **H 01 L 27/06, H 01 L 21/82, H 01 L 29/40, H 01 L 23/52**

(54) **Integrierte Halbleiterschaltung mit bipolaren Bauelementen und Schottkydioden sowie Verfahren zur Herstellung derselben.**

(30) Priorität : **12.08.82 DE 3230050**

(43) Veröffentlichungstag der Anmeldung :
**22.02.84 Patentblatt 84/08**

(45) Bekanntmachung des Hinweises auf die Patenterteilung : **05.04.89 Patentblatt 89/14**

(84) Benannte Vertragsstaaten :
**BE DE FR GB IT LU NL SE**

(56) Entgegenhaltungen :
**EP--A-- 0 000 743**
**EP--A-- 0 002 670**
**EP--A-- 0 002 670**
**IBM TECHNICAL DISCLOSURE BULLETIN, Band 23, Nr. 12, Mai 1981, Seiten 5396-5399, New York, US; C.G. JAMBOTKAR: "Mask alignment - independent base resistance minimization in NPN transistors without degradation of the emitter-base junction characteristics"**
**IBM TECHNICAL DISCLOSURE BULLETIN, Band 22, Nr. 8A, Januar 1980, Seiten 3206-3207, New York, US; L. BERENBAUM et al.: "Metal silicides for Schottky barrier diode applications"**
**PATENTS ABSTRACTS OF JAPAN, Band 6, Nr. 194 (E-134) [1072], 2. Oktober 1982; & JP - A - 57 106 156 (HITACHI SEISAKUSHO K.K.) 01.07.1982**
**SOLID STATE TECHNOLOGY, Band 24, Nr. 1, Januar 1981, Seiten 65-72 und 92, Port Washington, New York, US; F. MOHAMMADI: "Silicides for interconnection technology"**

(73) Patentinhaber : **Siemens Aktiengesellschaft Berlin und München**
**Wittelsbacherplatz 2**
**D-8000 München 2 (DE)**

(72) Erfinder : **Neppl, Franz, Dr.**
**St. Quirin Platz 6**
**D-8000 München 90 (DE)**
Erfinder : **Schwabe, Ulrich, Dr.**
**Grünwalder Strasse 40**
**D-8000 München 90 (DE)**

EP 0 100 999 B1

## Beschreibung

Die Erfindung betrifft eine integrierte Halbleiterschaltung mit mindestens einem Bipolartransistor und mindestens zwei Schottky-Dioden, bei der die beiden Schottky-Dioden nebeneinander an denselben Leitfähigkeitstyp aufweisenden Stellen der Oberfläche eines Halbleiterkristalls derart erzeugt sind, daß die erste Schottky-Diode eine niedrigere Schwellspannung als die zweite Schottky-Diode aufweist, und bei der die Kontakte aus der Metall-Leiterbahnebene zu den diffundierten aktiven Bereichen der Schaltung über zusätzlich erzeugte Leiterbahnen erfolgen, sowie ein Verfahren zu ihrer Herstellung.

Die kleinsten möglichen Abmessungen von Bipolar-Transistoren sind durch das relativ grobe Metallisierungsraster bestimmt, da aus der Metall-Leiterbahnebene Kontakte sowohl zur Emitter- und Kollektorzone als auch zur Basiszone hergestellt werden müssen.

Es gibt viele Versuche, das Verdrahtungsproblem zum Beispiel durch eine Polysiliziumverdrahtung, wie in IEEE Trans. Electron Devices, Vol. ED-27, No. 8, August 1980, auf den Seiten 1379 bis 1384 in einem Aufsatz von D. D. Tang et al beschrieben, oder durch eine Polyzidverdrahtung, wie in IEEE Trans. Electron Devices, Vol. ED-27, No. 8, August 1980, auf den Seiten 1385 bis 1389 in einem Aufsatz von Y. Sasaki et al beschrieben, zu entschärfen. Polysilizium-Verdrahtungen sind jedoch relativ hochohmig und haben hohe Serienwiderstände zur Folge. Da bei diesem Vorgehen in der Regel der Emitter aus dem Polysilizium ausdiffundiert wird, da die $n^-$- und $p^-$-Dotierungen ineinander diffundieren, ergibt sich außerdem eine hohe Emitter/Basis-Kapazität, wodurch die Grenzfrequenz beeinträchtigt wird. Die in dem Aufsatz von Sasaki veröffentlichte Anwendung von einer aus Molybdänsilizid bestehenden Verdrahtung reduziert zwar den Verdrahtungswiderstand gegenüber der Polysiliziumverdrahtung erheblich. Das Verfahren zur Herstellung dieser Art von Verdrahtung ist aber sehr maskenaufwendig.

Es sind Anwendungen bekannt, in denen ein Bipolartransistor und zwei verschiedene Schottky-Dioden-Typen in einer integrierten Schaltung erforderlich sind (siehe DE-PS 25 24 579).

Es ist Aufgabe der Erfindung, eine integrierte Schaltung mit bipolaren Bauelementen, insbesondere Bipolartransistoren, und zwei Typen von Schottky-Dioden anzugeben, bei der die Kontaktierung und Verbindung von Basis-, Emitter- und Kollektorgebieten unabhängig vom Metallisierungsraster ist, also relativ wenig Platz erfordert und daher eine hohe Packungsdichte ermöglicht. Desweiteren soll der Schichtwiderstand der Diffusionsgebiete reduziert werden. Gleichzeitig sollen die verschiedenen Schottky-Dioden gebildet werden, wobei die für die Kontaktierung und Verbindung der aktiven Transistorbereiche verwendeten Metalle auch die Kontakte der Dioden darstellen.

Es ist auch Aufgabe der Erfindung, ein Verfahren zur Herstellung der eingangs genannten Schaltung in möglichst einfachen, maskensparenden Verfahrensschritten anzugeben.

Die erfindungsgemäße Lösung dieser Aufgabe ist dadurch gekennzeichnet, daß die Emitter- und Kollektorkontakte des Bipolartransistors sowie der Kontakt der ersten Schottky-Diode aus einem direkt abgeschiedenen Silizid der Metalle Tantal, Wolfram, Molybdän oder Titan und der Basiskontakt des Bipolartransistors sowie der Kontakt der zweiten Schottky-Diode aus Aluminium oder der Schichtenfolge Platin Silizid/Aluminium besteht.

Neben der so erreichten Unabhängigkeit von Metallisierungsraster und der Niederohmigkeit der zusätzlichen Verdrahtung ermöglicht die (nur teilweise) Verwendung der Silizidverdrahtung in Verbindung mit der Hochtemperaturbeständigkeit des Silizids die gleichzeitige Verwendung als Implantationsmaske. Dadurch kann der Vorteil einer zusätzlichen Verdrahtung ohne Aufwendung von zusätzlichen Fotolithographieschritten genützt werden, da die Basiskontaktmaske entfallen kann.

Durch das Verfahren nach der Lehre der Erfindung ist die Möglichkeit gegeben, das Metallsilizid wegen der geringen Barrierenhöhe gleichzeitig für den in manchen Anwendungen (siehe DE-PS 25 24 579) neben der üblichen Aluminium- oder Aluminium/Platin-Silizid-Schottky-Diode benötigten zweiten Schottky-Dioden-Typs zu verwenden.

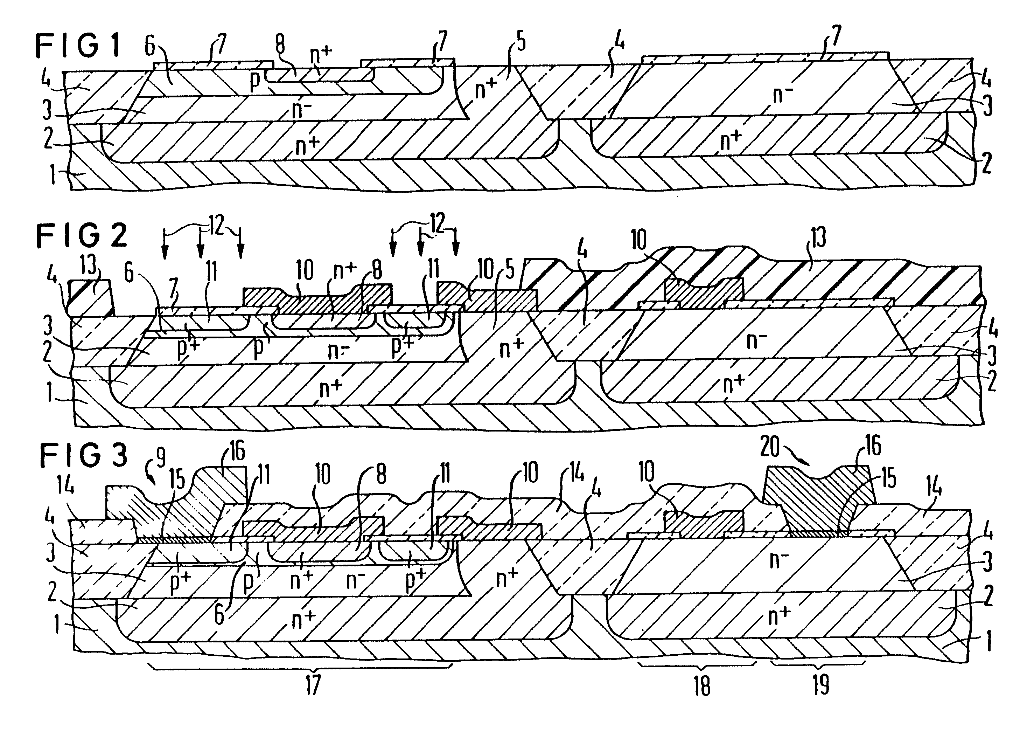

Im folgenden wird anhand der Figuren 1 bis 3 der Prozeßablauf für die Herstellung einer erfindungsgemäßen Schaltung mit einem Bipolartransistor und zwei Typen von Schottky-Dioden näher beschrieben. Dabei sind in den Figuren im Schnittbild nur die erfindungswesentlichen Verfahrensschritte dargestellt ; gleiche Teile sind mit gleichen Bezugszeichen versehen.

Figur 1 : Auf einer einkristallinen, p-dotierten (100)-orientierten Siliziumsubstratscheibe 1 mit einem spezifischen Widerstand von 10 Ohm cm werden die aktiven Bereiche der Schaltung durch Herstellen von $n^-$-dotierten Zonen 2 durch maskierte Ionenimplantation festgelegt. Dann wird durch ein epitaktisches Abscheideverfahren auf die $n^-$-dotierten Zonen 2 eine n-dotierte Siliziumschicht mit einem spezifischen Widerstand von 2 Ohm cm aufgebracht und mittels einer, die aktiven Gebiete 2 abdeckenden Maske der Isolationsgraben geätzt (in der Figur nicht dargestellt). Im Anschluß daran wird im Bereich des Isolationsgrabens das Isolationsoxid 4 erzeugt. Dann wird nach Aufbringen einer die übrigen Bereiche maskierenden Schicht die $n^-$-Tiefdiffusion 5 im Kollektorbereich des Bipolartransistors und nach Entfernen der Maske für die Kollektortiefdiffusion 5 und Aufbringen einer erneuten Maske die Basisimplantation 6 mit Bor-Ionen durchgeführt.

Zur Festlegung der Emitterzonen (8) wird ein Fotolithografieprozeß durchgeführt und dabei die bei der Basisdiffusion 6 entstandene Oxidschicht 7 im Emitterbereich (8) entfernt. Die Emitterzone 8 wird durch Implantation und Diffusion von Arsen-Ionen erzeugt.

Figur 2 : Zur Festlegung des Kontaktes der ersten Schottky-Diode (18) sowie der Kontakte für Emitter (8)- und Kollektorzone (2, 5) wird eine Fotolithografietechnik durchgeführt und die Oxidschicht 7 in diesen Bereichen entfernt. Dann wird ganzflächig die Metallsilizidschicht (10) in einer Schichtdicke von 200 nm aufgebracht und so strukturiert, daß sie im Bereich des Bipolartransistors (17) bei der anschließenden Basiskontaktimplantation 11 als Implantationsmaske dient. Vor der Durchführung der Basiskontaktimplantation 11 mit Bor-Ionen 12 wird der Schottky-Diodenbereich (18, 19) mit einer Fotolacktechnik 13 abgedeckt.

Figur 3 : Nach Entfernung der Fotolackschicht 13 wird ein Temperprozeß durchgeführt und die Silizidschichtstruktur 10, welche zum Beispiel aus Tantalsilizid besteht, kristallisiert. Nach Abscheidung der als Zwischenoxid wirkenden Isolationsschicht 14 werden die Kontaktlochbereiche für den Basiskontakt 9 des Bipolartransistors (17) und den Kontakt 20 der zweiten Schottky-Diode (19) freigeätzt und in bekannter Weise die Metallisierung und Strukturierung der äußeren Metall-Leiterbahnebene 15, 16 durchgeführt. Dabei kann eine aus Aluminium oder der Schichtfolge Platinsilizid I5/Aluminium 16 bestehende Doppelschicht verwendet werden. In der Figur 3 ist mit der Klammer 17 der Bipolartransistorbereich, mit der Klammer 18 die erste Schottky-Diode mit Tantalsilizidkontakt und mit der Klammer 19 die zweite Schottky-Diode mit dem Platinsilizid/Aluminiumkontakt bezeichnet. Anstelle von Tantalsilizid können auch die Silizide der Metalle Titan, Molybdän und Wolfram verwendet werden.

Die erste Schottky-Diode 18 weist eine Schwellspannung von 0,59 V, die zweite Schottky-Diode 19 von 0,84 V auf.

**Patentansprüche**

1. Integrierte Halbleiterschaltung mit mindestens einem Bipolartransistor (17) und mindestens zwei Schottky-Dioden (18, 19), bei der die beiden Schottky-Dioden (18, 19) nebeneinander an denselben Leitfähigkeitstyp aufweisenden Stellen der Oberfläche (3) eines Halbleiterkristalls (1) derart erzeugt sind, daß die erste Schottky-Diode (18) eine niedrigere Schwellspannung als die zweite Schottky-Diode (19) aufweist und bei der die Kontakte aus der Metall-Leiterbahnebene zu den diffundierten aktiven Bereichen der Schaltung über zusätzlich erzeugte Leiterbahnen (10) erfolgen, dadurch gekennzeichnet, daß die Emitter (8)- und Kollektorkontakte (5) des Bipolartransistors (17) sowie der Kontakt der ersten Schottky-Diode (18) aus einem direkt abgeschiedenen Silizid (10) der Metalle Tantal, Wolfram, Molybdän oder Titan und der Basiskontakt (9) des Bipolartransistors (17) sowie der Kontakt (20) der zweiten Schottky-Diode (19) aus Aluminium (16) oder der Schichtenfolge Platinsilizid/Aluminium (15, 16) besteht.

2. Verfahren zum Herstellen einer integrierten Halbleiterschaltung mit mindestens einem npn-Bipolartransistor (17) und mindestens zwei Typen (18, 19) von Schottky-Dioden nach Anspruch 1, gekennzeichnet durch den Ablauf der folgenden Verfahrensschritte :

a) Festlegung der aktiven Bereiche der Schaltung durch Herstellen von n⁻-dotierten Zonen (2) in einem p-dotierten Siliziumsubstrat (1) durch maskierte Ionenimplantation,

b) Aufbringen einer epitaxialen n-dotierten Schicht (3) auf die n⁻-dotierten Zonen (2),

c) maskiertes Ätzen des Isolationsgrabens im Bereich zwischen den n⁻-dotierten Zonen (2),

d) Erzeugen des Isolationsoxids (4) im Bereich des Isolationsgrabens,

e) n⁻-Tiefdiffusion im Kollektorbereich (5) nach Aufbringen einer, die übrigen Bereiche maskierenden Schicht,

f) Durchführung der Basisimplantation (6) mit p-dotierenden Ionen nach Ablösung der maskierenden Schicht für die Kollektor-Tief-Diffusion (5) und nach Erzeugung der Maske für die Basisimplantation (6),

g) Durchführung der Fotolithographietechnik zur Festlegung der Emitterzone (8) und Abätzung der bei der Basisdiffusion entstandenen Oxidschicht (7) im Emitterbereich (8),

h) Erzeugen der Emitterzone (8) durch Ionenimplantation und Eindiffusion von n-dotierenden Ionen,

i) Durchführung der Fotolithographietechnik zur Festlegung des Kontaktes der ersten Schottky-Diode (18) sowie der Kontakte für Emitter (8)- und Kollektorzonen (5) und Abätzen der Oxidschichten in diesen Bereichen,

j) Abscheidung einer ganzflächigen Silizidschicht und Strukturierung der, als zusätzliche Leiterbahn dienenden Silizidschicht (10) im Bereich des Bipolartransistors (17) so, daß sie bei der anschließenden Basiskontaktimplantation (11) als Implantationsmaske dient,

k) Abdecken des Schottky-Diodenbereiches (18, 19) mit einer Fotolackschicht (13),

l) Durchführung der Basiskontaktimplantation (11) mit p-dotierenden Ionen (12),

m) Temperung der Silizidschicht (10) nach Entfernung der Fotolackschicht (13), bei der gleichzeitig die Basiskontaktimplantation (11) elektrisch aktiviert wird,

n) Abscheidung der als Zwischenoxid wirkenden Isolationsschicht (14),

o) Ätzung der Kontaktlochbereiche (9) für den Basiskontakt des Bipolartransistors (17) und den Kontakt (20) der zweiten Schottky-Diode (19),

p) Durchführung der Metallisierung (15, 16) und Strukturierung der äußeren Metall-Leiterbahnebene.

3. Verfahren nach Anspruch 2, dadurch gekennzeichnet, daß als Silizid (10) bei Verfahrensschritt j) ein Silizid eines der Metalle Tantal, Titan, Wolfram oder Molybdän verwendet wird.

4. Verfahren nach Anspruch 2 und 3, dadurch gekennzeichnet, daß für die Emitter-Implantation (8) bei Verfahrensschritt h) Arsen-Ionen und für die Basiskontaktierung bei Verfahrensschritt l) Bor-Ionen (12) verwendet werden.

5. Verfahren nach Anspruch 2 bis 4, dadurch gekennzeichnet, daß als Metallisierung für die äußere Metall-Leiterbahnebene gemäß Verfahrensschritt p) Aluminium oder die Schichtenfolge Platinsilizid/Aluminium (15, 16) verwendet wird.

6. Verfahren nach Anspruch 2 bis 5, dadurch gekennzeichnet, daß als Ausgangsmaterial (100)-orientiertes, p-dotiertes Silizium (1) mit einem spezifischen Widerstand im Bereich von 10 Ohm × cm verwendet wird.

7. Verfahren nach Anspruch 2 bis 6, dadurch gekennzeichnet, daß der spezifische Widerstand der n-dotierten Epitaxieschicht (3) gemäß Verfahrensschritt b) auf den Bereich von 2 Ohm × cm eingestellt wird.

**Claims**

1. Integrated semiconductor circuit comprising at least one bipolar transistor (17) and at least two Schottky diodes, in which circuit the two Schottky diodes (18, 19) are produced next to each other at positions having the same conductivity type on the surface (3) of a semiconductor crystal (1) in a manner such that the first Schottky diode (18) has a lower threshold voltage than the second Schottky diode (19), and in which circuit the contacts from the metal conductor track level to the diffused active regions of the circuit take place by additionally produced conductor tracks (10), characterized in that the emitter (8) and collector (5) contacts of the bipolar transistor (17) and also the contact of the first Schottky diode (18) are composed of a directly deposited silicide (10) of the metals tantalum, tungsten, molybdenum or titanium and the base contact (9) of the bipolar transistor (17) and also the contact (20) of the second Schottky diode (19) is composed of aluminium (16) or the layer sequence platinum silicide/aluminium (15, 16).

2. Method of producing an integrated semiconductor circuit comprising at least one npn bipolar transistor (17) and at least two types (18, 19) of Schottky diodes according to claim 1, characterized by the sequence of the following process steps :

a) defining the active regions of the circuit by producing n⁻-doped zones (2) in a p-doped silicon substrate (1) by masked ion implantation,

b) deposition of an epitaxial n-doped layer (3) on the n⁻-doped zones (2),

c) masked etching of the isolation trench of the region between the n⁻-doped zones (2),

d) production of the isolation oxide (4) in the region of the isolation trench,

e) n⁻ deep diffusion in the collector region (5) after deposition of a layer which masks the remaining regions,

f) carrying out of the base implantation (6) with p-doping ions after stripping off the masking layer for the collector deep diffusion (5) and after producing the mask for the base implantation (6),

g) carrying out of the photolithographic technique to define the emitter zone (8) and etching away of the oxide layer (7) in the emitter region (8) produced during the base diffusion,

h) production of the emitter zone (8) by ion implantation and drive-in of n-doping ions,

i) carrying out of the photolithographic technique to define the contact of the first Schottky diode (18) and also the contacts for the emitter (8) and collector (5) zones and etching away of the oxide layers in these regions,

j) deposition of a silicide layer over the entire surface and structuring of the silicide layer (10), which acts as an additional conductor track, in the region of the bipolar transistor (17) so that it acts as implantation mask in the subsequent base contact implantation (11),

k) coating of the Schottky diode region (18, 19) with a photoresist layer (13),

l) carrying out of the base contact implantation (11) with p-doping ions (12),

m) annealing of the silicide layer (10) after removing the photoresist layer (13), during which annealing the base contact implantation (11) is simultaneously activated electrically,

n) deposition of the insulation layer (14) which acts as intermediate oxide,

o) etching of the contact hole regions (9) for the base contact of the bipolar transistor (17) and the contact (20) of the second Schottky diode (19),

p) carrying out of the metallization (15, 16) and structuring of the outer metal conductor track level.

3. Method according to Claim 2, characterized in that a silicide or one of the metals tantalum, titanium, tungsten or molybdenum is used as silicide (10) in process step j).

4. Method according to Claim 2 and 3, characterized in that arsenic ions are used for the emitter implantation (8) in process step h) and boron ions (12) for making the base contact in process step l).

5. Method according to Claim 2 to 4, characterized in that aluminium or the layer sequence platinum silicide/aluminium (15, 16) is used as metallization for the outer metal conductor track level according to process step p).

6. Method according to Claim 2 to 5, characterized in that (100)-oriented p-doped silicon (1) having a specific resistance in the region of 10 ohm × cm is used as starting material.

7. Method according to Claim 2 to 6, characterized in that the specific resistance of the n-doped epitaxial layer (3) according to process step b) is adjusted to the region of 2 ohm × cm.

**Revendications**

1. Circuit intégré à semiconducteurs comportant au moins un transistor bipolaire (17) et au moins deux diodes Schottky (18, 19), et dans lequel les deux diodes Schottky (18, 19) sont formées côte-à-côte en des emplacements, possédant le même type de conductivité, de la surface (3) d'un cristal semiconducteur (1) de telle sorte que la première diode Schottky (18) possède une tension de seuil plus faible que la seconde diode Schottky (19), et dans lequel les contacts partant du plan des voies conductrices métalliques pour aboutir aux zones actives du circuit, formées par diffusion, sont réalisés au moyen de voies conductrices (10) prévues en supplément, caractérisé par le fait que le contact d'émetteur (8) et le contact de collecteur (5) du transistor bipolaire (17) ainsi que le contact de la première diode Schottky (18) sont constitués par un siliciure (10), déposé directement, des métaux : tantale, tungstène, molybdène ou titane, et le contact de base (9) du transistor bipolaire (17) ainsi que le contact (20) de la seconde diode Schottky (19) sont constitués par de l'aluminium (16) ou par une suite de couches : siliciure de platine/aluminium (15, 16).

2. Procédé pour fabriquer un circuit intégré à semiconducteurs comportant au moins un transistor bipolaire npn (17) et au moins deux types (18, 19) de diodes Schottky suivant la revendication 1, caractérisé par l'exécution des étapes opératoires suivantes :

a) délimitation des régions actives du circuit au moyen de la fabrication de zones (2) dopées du type n⁻ dans un substrat en silicium (1) dopé du type p, au moyen d'une implantation ionique avec masquage,

b) dépôt d'une couche épitaxiale (3) dopée du type n suivant les zones (2) dopées du type n⁻,

c) corrosion, avec masquage, du sillon isolant dans la région située entre les zones (2) dopées du type n⁻,

d) fabrication de l'oxyde isolant (4) dans la région du sillon isolant,

e) diffusion partielle de type n⁻ dans la région de collecteur (5) après le dépôt d'une couche masquant les autres régions,

f) mise en oeuvre de l'implantation de base (6) avec des ions réalisant un dopage de type p après élimination de la couche de masquage, pour la diffusion profonde (5) du collecteur, et après la formation du masque pour l'implantation de base (6),

g) mise en oeuvre de la technique photolithographique pour former la zone d'émetteur (8), et élimination par corrosion de la couche d'oxyde (7), apparaissant lors de la diffusion de base, dans la région d'émetteur (8),

h) formation de la zone d'émetteur (8) par implantation ionique et diffusion pénétrante d'ions réalisant un dopage de type n,

i) mise en oeuvre de la technique photolithographique pour former le contact de la première diode Schottky (18) ainsi que les contacts pour la zone d'émetteur (8) et la zone de collecteur (5) et élimination par corrosion des couches d'oxyde dans ces régions,

j) dépôt d'une couche de siliciure sur toute la surface et structuration de la couche de siliciure (10), utilisée comme voie conductrice supplémentaire, dans la région du transistor bipolaire (17), de manière qu'elle serve de masque d'implantation lors de l'implantation ultérieure (11) du contact de base,

k) recouvrement de la région des diodes Schottky (18, 19) avec une couche de laque photosensible (13),

l) exécution de l'implantation (11) du contact de base avec des ions (12) réalisant un dopage de type p,

m) recuit de la couche de siliciure (10) après élimination de la couche de laque photosensible (13), au cours duquel l'implantation (11) du contact de base est simultanément activée par voie électrique,

n) dépôt de la couche isolante (14) agissant en tant qu'oxyde intermédiaire,

o) corrosion des régions (9) des trous de contact pour le contact de base du transistor bipolaire (17) et pour le contact (20) de la seconde diode Schottky (19),

p) exécution de la métallisation (15, 16) et structuration du plan extérieur des voies conductrices métalliques.

3. Procédé suivant la revendication 2, caractérisé par le fait qu'on utilise, comme siliciure (10) intervenant lors de l'étape opératoire j), un siliciure des métaux : tantale, titane, tungstène ou molybdène.

4. Procédé suivant les revendications 2 et 3, caractérisé par le fait qu'on utilise des ions d'arsenic pour l'implantation (8) d'émetteur intervenant lors de l'étape opératoire h) et qu'on utilise des ions de bore (12) pour l'établissement du contact de base intervenant lors de l'étape opératoire l).

5. Procédé suivant les revendications 2 à 4, caractérisé par le fait qu'on utilise, comme métallisation pour le plan extérieur des voies conductrices métalliques, lors de l'étape opératoire p), de l'aluminium ou la suite de couches siliciure de platine/aluminium (15, 16).

6. Procédé suivant les revendications 2 à 5, caractérisé par le fait qu'on utilise, comme matériau de départ, du silicium (1) dopé du type p, présentant l'orientation (100) et possédant une résistance spécifique de l'ordre de 10 ohms × cm.

7. Procédé suivant les revendications 2 à 6, caractérisé par le fait qu'on règle la résistance spécifique de la couche épitaxiale (3) dopée du type n déposée lors de l'étape opératoire b), d'une valeur de l'ordre de 2 ohms × cm.

**FIG 1**

6　7　8　n+　7　5　4　7

4

3

p

n+

n−

n−

2

n+

n+

1

**FIG 2**

12　12　10　13

4　13　6　7　11　10　n+　8　11　10　5　4

3

2

p+　p+　n−　p+

n+

n−

1

n+

n+

**FIG 3**

9　16　20　16

14　15　11　10　8　11　10　14　4　10　15　14

4

3

2

p+　p+　n+　n−　p+

n+

n−

1

6　n+

n+

17　18　19

EP 0 100 999 B1